# EUROPÄISCHE PATENTSCHRIFT

(11) **EP 1 788 674 B1**
(45) Veröffentlichungstag und Bekanntmachung des Hinweises auf die Patenterteilung: **09.03.2016**
(21) Anmeldenummer: 06090192.3
(22) Anmeldetag: 18.10.2006
(51) Int. Cl.: H01S 5/026, H01S 5/18

(54) **Laserdiode mit integrierter Monitordiode**
Laserdiode with integrated monitordiode
Laser à diode avec monitor à diode integré

(30) Priorität: 01.11.2005 DE 102005052772
(43) Veröffentlichungstag der Anmeldung: 23.05.2007
(73) Patentinhaber: Fraunhofer-Gesellschaft zur Förderung der angewandten Forschung e.V., 80686 München (DE)
(72) Erfinder: Grote, Norbert, 14052 Berlin (DE); Möhrle, Martin, 12683 Berlin (DE); Sigmund, Ariane, 10243 Berlin (DE)
(74) Vertreter: Andrae | Westendorp Patentanwälte Partnerschaft

(56) Entgegenhaltungen:
- FR-A- 2 655 775
- US-A- 4 674 100
- US-A1- 2005 123 016
- US-B1- 6 274 891

## Beschreibung

Die Erfindung bezieht sich auf eine Laserdiode mit monolithisch integriertem p-n-p- oder n-p-n-Halbleiterschichtaufbau mit einer aktiven Laserschicht zwischen den oberen beiden p-n- oder n-p-Halbleiterschichten auf einer Substratschicht, einer Licht auskoppelnden Frontfacette, einer Licht rückkoppelnden Rückfacette und mit einer integrierten n-p- oder p-n-Monitordiode mit einer flächigen aktiven Monitordiodenschicht.

In optischen Sendemodulen werden Laserdioden fast ausschließlich in Kombination mit einer zumeist im Bereich der Rückfacette angeordneten Monitordiode eingesetzt. Diese dient dazu, die von der Laserdiode emittierte optische Ausgangsleistung zu messen und damit dazu, die Lasertreiberschaltung anzusteuern. Ziel hierbei ist es, eine unter allen äußeren Änderungen, insbesondere unter Temperatur- und alterungsbedingten Änderungen, konstante optische Ausgangsleistung des Lasers an der Frontfacette zu gewährleisten. Gleichzeitig kann die Monitordiode den Laserbetrieb störende Reflexionen von der Rückfacette unterdrücken. Bei einem hybriden Aufbau von Monitor- und Laserdiode entstehen neben den Herstellungskosten einer solchen Monitordiode zusätzliche Kosten bei deren Montage in das Laser-Sendemodul.

### Stand der Technik

Aus der **Veröffentlichung** "Monolithically Integrated Dipleicer Chip for PON Applications" von A. Behfar et al. (Paper OTuM5, Optical Fiber Conference 2005, March 6-11, 2005, Anaheim, California, USA; vergleiche auch die WO 2005/072224 A2 vom 11.08.2005 sowie US 2005/0123016 A1) ist eine p-n-p-Laserstruktur in Schichtaufbau bekannt, die in der Ausbildung eines Fabry-Perot-Lasers eine Laserdiode als Sender und eine Photodiode als Empfänger für Laserlicht unterschiedlicher Wellenlängen monolithisch in einem Diplexer-Chip für passive optische Netzwerke (PON) vereint und eine monolithisch integrierte Monitordiode aufweist. Die aktive Laserschicht befindet sich zwischen den oberen beiden p-n-Schichten. Die Lichtauskopplung erfolgt vertikal an einer um 45° von der aktiven Laserschicht weg geneigten Frontfacette. Die Monitordiode nutzt die aktive Laserschicht gleichzeitig als aktive Monitordiodenschicht und ist somit mit der Laserdiode optisch in Reihe geschaltet. Monitordiode und Laserdiode sind durch eine vertikale Ätzgrube, die bis in die n-Schicht hineinragt, von einander getrennt. Die vertikale Ätzgrube wirkt jedoch gleichzeitig als Licht in die aktive Laserschicht rückkoppelnde Rückfacette. Ein Teil des in der aktiven Laserschicht erzeugten Lichts gelangt in die Monitordiodenschicht. Die Verwendung der aktiven Laserschicht als Monitordiodenschicht muss aber auf Laser vom Fabry-Perot-Typ beschränkt bleiben, da nur hier das Emissionsspektrum und die Absorptionskante der Monitordiodenschicht dieselbe Temperaturabhängigkeit aufweisen. Bei einem DFB-Laser verschiebt sich die Emissionswellenlänge dagegen gitterbedingt weniger stark mit der Temperatur als die Absorptionskante der Monitordiodenschicht, was bei einem ungekühlten Betrieb zu einer störenden, temperaturabhängigen Empfindlichkeit der Monitordiode im Bereich der zu überwachenden Wellenlänge führt.

Weiterhin ist bei dem aus der oben genannten Veröffentlichung bekannten Diplexer-Chip unterhalb der aktiven Laserschicht zwischen den unteren beiden n-p-Schichten eine aktive flächige Photodiodenschicht angeordnet, die jedoch Teil der empfangenen Photodiode ist. Dabei ist die empfangende Photodiode für eine andere Wellenlänge ausgelegt (1450 nm) als die sendende Laserdiode (1310 nm). Eine Überwachungsfunktion im Sinne der Monitordiode kann mit der Photodiode nicht erfolgen, da eine interne Auskopplung von erzeugtem Laserlicht in die Photodiodenschicht störenden Crosstalk zwischen den unter schiedlichen Wellenlängen von Sende- und Empfangssignal hervorrufen würde und somit bei dem Diplexer-Chip nicht zulässig ist. Schließlich wird bei dem bekannten Diplexer-Chip ein semiisiolierendes Substrat verwendet, das nicht leitfähig ist und damit nicht zu einer Kontaktierung eingesetzt werden kann.

Bekannte Ansätze zur Integration von Monitordioden beruhen auf einer horizontalen seriellen Anordnung von Laserdiode und Monitordiode mit einer gemeinsamen Nutzung der aktiven Laserschicht auch als Monitordiodenschicht, was aber insbesondere bei DFB-Lasern nur für eine konstante Betriebstemperatur verwendet werden kann.

Die in der US 6 274 891 B1 beschriebene Laserdiode dient der vertikalen Lichtauskopplung und weist einen monolithisch integrierten Halbleiterschichtaufbau auf. Eine aktive Laserschicht ist zwischen p-n- oder n-p-Halbleiterschichten auf einer Substratschicht angeordnet. Die Laserdiode weist zwei Facetten auf. Eine Frontfacette, die unter einem Neigungswinkel β zur aktiven Laserschicht geneigt ist, dient der vertikalen Lichtauskopplung. Eine Rückfacette, die unter einem Neigungswinkel α zur aktiven Laserschicht hin geneigt ist, wobei beide Neigungswinkel α, β größer 0° und kleiner 90°sind, dient der Lichtrückkopplung in eine integrierte n-p- oder p-n-Monitordiode. Diese ist im Bereich der Rückfacette unterhalb der aktiven Laserschicht in die Laserdiode integriert. Die Laserdiode ist in Durchlassrichtung und die Monitordiode ist in Sperrrichtung für den Strom geschaltet, sodass sich beide Dioden gegenseitig nicht beeinflussen.

Die Monitordiode gemäß der US 6 274 891 B1 ist jedoch nicht in den Halbleiterschichtaufbau monolithisch integriert, sondern unterhalb der Substratschicht angeordnet. Sie muss daher entweder in einem Epitaxieprozess der aktiven Laserschicht gesonderten Epitaxieprozess aufgebracht oder hybrid angebracht werden. Die beiden Facetten sind entgegengesetzt orientiert und reflektieren das Licht in dieselbe Richtung. Die Laserdiode emittiert vertikal durch das Substrat hindurch. Ein DFB- oder DBR-Gitter zur monomodigen Lichtauskopplung einer Wellenlänge ist bei der bekannten Laserdiode nicht vorgesehen. Der Betrieb ist daher nicht monomodig. Eine Emission einer stabilen Wellenlänge kann nicht garantiert werden.

Aus der US 4 674 100 ist eine horizontal emittierende Laserdiode (Kantenemitter) bekannt, bei der die Lichteinkopplung in die Monitordiodenschicht mittels eines Gitters höherer Ordnung erfolgt. Die Monitordiodenschicht wird nach Polieren der Rückseite der Substratschicht separat aufgewachsen. Die monolithisch integrierte, auf der Unterseite der Halbleiterschicht liegende Monitordiode wird durch Zn-Diffusion in die Monitordiodenschicht erzeugt. Durch das getrennte Aufwachsen der Aktivschicht der Laserdiode vom Aufwachsen der Photodiodenschicht ist eine monolithische Integration der Photodiodenschicht in den Halbleiterschichtaufbau unterhalb der aktiven Laserschicht, aber oberhalb der Substratschicht nicht vorgesehen.

Schließlich offenbart die FR 2 655 775 A1 ebenfalls eine horizontal emittierende Laserdiode (Kantenemitter) mit einer einzelnen unterätzten spiegelnden Facette, die der Kopplung von Licht in die Monitordiode dient. Diese ist oberhalb der Aktivschicht der Laserdiode angeordnet. Eine DFB- oder DBR-Laserstruktur ist hier nicht offenbart.

Aus der US 2005/0123 016 A1 ist eine vertikal über eine nicht entspiegelte Frontfacette emittierende Laserdiode bekannt, bei der die Monitordiode durch Verwendung der aktiven Laserschicht realisiert wird. Diese Laserdiode ist als Vorläufer zu der Laserdiode gemäß der WO 2005/072224 A2 anzusehen und verfügt über keine eigene durchgängige aktive Monitordiodenschicht. Ein DFB- oder DBR-Gitter ist nicht vorgesehen, es handelt sich vielmehr um eine Fabry-Perot-Laserdiode mit externem Gitter, das durch die gesamte aktive Laserschicht hindurchgeätzt wird. Eine Lichtauskopplung in die Monitordiode über eine geneigte Rückfacette ist nicht vorgesehen, vielmehr erreicht das erzeugt Laserlicht die Monitordiode über die aktive Laserschicht. Es gelten die im Zusammenhang mit der Laserdiode gemäß der WO 2005/072224 A2 genannten Nachteile.

### Aufgabenstellung

Ausgehend von der Laserdiode gemäß dem vorstehend gewürdigten Stand der Technik in der US 6 274 891 B1 ist die **Aufgabe** für die vorliegende Erfindung darin zu sehen, eine Laserdiode mit einer integrierten Monitordiode anzugeben, die einen monomodigen, wellenlängenstabilen Betrieb ermöglicht und einen kompakten Aufbau zeigt, der in einfacher und günstiger Weise herstellbar ist. Dabei sollen die Vorteile der bekannten Laserdiode erhalten bleiben, dass die Monitordiode ein temperaturunabhängiges Messverhalten zeigt und den Laserbetrieb nicht stört.

Die erfindungsgemäße **Lösung** dieser Aufgabe ist dem Hauptanspruch zu entnehmen. Vorteilhafte Weiterbildungen der Erfindung werden in den Unteransprüchen aufgezeigt, die im Folgenden im Zusammenhang mit der Erfindung näher erläutert werden.
Bei der erfindungsgemäßen Laserdiode weist die Rückfacette einen Neigungswinkel α größer 0° und kleiner 90° bezogen auf die aktive Laserschicht im Winkel α gleich 0° auf. Somit wird das in die Rückfacette einfallende Laserlicht gezielt und erwünscht ganz oder teilweise nach unten in Richtung auf die Substratschicht reflektiert. Rückkopplungen in die aktive Laserschicht werden so vermieden bzw. können durch die Wahl des Neigungswinkels gezielt hervorgerufen und eingestellt werden. Dabei hängt der gewählte Neigungswinkel vom anwendungsabhängig gewählten Typ der Laserdiode ab. Eine maximale Lichtumlenkung ergibt sich bei einem Neigungswinkel gleich oder kleiner als 45°. Bei größeren Neigungswinkeln steigt der in die aktive Laserschicht reflektierte Lichtanteil stetig an. Die Grenzwinkel sind 90° (Rückfacette vertikal zur Laserschicht), bei dem alles auftreffende Licht in den Laser reflektiert wird und 0° (Rückfacette parallel zur Laserschicht), bei dem kein Laserlicht auf die Rückfacette auftreffen kann. Die Monitordiode würde in diesen Grenzfällen nur mit Streulicht betrieben werden können.

Unterhalb der aktiven Laserschicht der erfindungsgemäßen Laserdiode befindet sich parallel dazu die aktive Monitordiodenschicht zwischen den unteren beiden n-p- oder p-n-Halbleiterschichten, sodass das von der Rückfacette nach unten reflektierte Licht in die aktive Monitordiodenschicht einfällt und dort absorbiert wird. Die Monitordiode ist somit optisch parallel zur Laserdiode geschaltet. Die Abfolge der unteren beiden H albleiterschichten bestimmen dabei, ob eine n-p- oder um eine p-n-Monitordiode konzipiert wird. Dabei ist die flächige Monitordiodenschicht zumindest im Bereich der Rückfacette ausgebildet, vorteilhaft für eine besonders einfache Herstellung des Laserschichtaufbaus durch problemloses Abscheiden erstreckt sie sich jedoch flächig unter der gesamten aktiven Laserschicht. Gegenüber der Laserdiode, die zwischen den oberen beiden p-n- oder n-p-Halbleiterschichten in Durchlassrichtung für den Strom geschaltet ist, ist die Monitordiode zwischen den unteren beiden n-p- oder p-n-Halbleiterschichten immer in Sperrrichtung für den Strom geschaltet. Es können somit beide Dioden über einen gemeinsamen Zweig geschaltet werden, ohne dass sie sich gegenseitig beeinflussen. Beide Dioden sind elektrisch in Reihe geschaltet. Durch die parallele monolithische Integration der Monitordiode entstehen nur marginale zusätzliche Kosten bei der Herstellung der Laserdiode nach der Erfindung. Außerdem ergibt sich eine große Modulkompaktheit, die durch die erreichte Platzeinsparung beispielsweise gegenüber einer optischen Reihenschaltung von Laser- und Monitordiode einen weiteren Vorteil darstellt. Durch die konstruktive Trennung und optische Parallelisierung von aktiver Laserschicht und Monitordiodenschicht bei der Laserdiode nach der Erfindung arbeitet die Monitordiode in jeder Laserbauform temperaturunabhängig. Somit wird stets ein zuverlässiges Messsignal im Bereich optimaler Absorption erzeugt.

Wenn die unterste Halbleiterschicht vorteilhaft gleichzeitig als Substratschicht ausgebildet ist, sodass dieses leitend ist, kann die integrierte Monitordiode in besonders einfacher Weise kontaktiert werden. Die Monitordiode kann dann auf der Ober- und Unterseite der Laserdiode elektrisch kontaktiert werden. Dabei ist der Kontakt auf der Unterseite der Substratschicht ein einfacher flächiger Kontakt. Durch den gegensätzlichen Betrieb der Laserdiode in Durchlassrichtung und der Monitordiode in Sperrrichtung kann nach der Erfindung in einem pnp-Halbleiterschichtaufbau vorteilhaft ein gemeinsamer n-leitender Kontakt für beide Dioden eingesetzt werden. In einem n-p-n-Halbleiterschichtaufbau kann entsprechend ein gemeinsamer p-leitender Kontakt ausgebildet werden. Weiterhin können beide Kontakte der Laserdiode auf deren Oberseite angeordnet sein, was eine Herstellungsvereinfachung und bessere Verschaltbarkeit der Laserkontakte bedeutet. Die Kontakte sind dann entsprechend elektrisch voneinander isoliert. Diese Konfiguration erlaubt auch eine Flip-Chip-Montage des Bauelementes.

In einer alternativen Bauform der Laserdiode nach der Erfindung wird zusätzlich ein vertikaler Spiegel mit einer Tiefe bis einschließlich zur aktiven Laserschicht integriert. Dieser unterstützt einerseits zuverlässig eine Rückkopplung in die aktive Laserschicht, sodass sich der Reflexionsanteil erhöht. Dadurch, dass der vertikale Spiegel aber nur bis zur aktiven Laserschicht reicht, ist eine Lichteinkopplung in die geneigte Rückfacette über die unter der aktiven Laserschicht liegenden p- oder n-leitenden Schicht trotzdem gewährleistet, sodass auch bei dieser Ausführungsform die Monitordiode sicher betrieben werden kann. Vorteilhaft kann der vertikale Spiegel als einfache Ätzgrube ausgebildet sein. Der flächig aufgebrachte oberseitige Kontakt der Laserdiode kann dann ebenfalls in diese Ätzgrube hineingreifen, um die Reflexionswirkung des vertikalen Spiegels zu erhöhen. Zusätzlich kann auch die Rückfacette noch durch eine Weiterführung des Kontaktes verspiegelt werden. Zur Vermeidung von Kurzschlüssen ist der Kontakt zur Ätzgrube und ggfs. auch zur Rückfacette durch eine dielektrische Schicht isoliert. Alternativ zu dieser metallischen Verspiegelung können auch eine zusätzliche dielektrische Verspiegelung der Rückfacette und/oder der vertikale Spiegel verwendet werden.

Ein besonderer Vorteil der Laserdiode nach der Erfindung mit integrierter Monotordiode liegt in der vielfältigen konstruktiven Gestaltbarkeit, sodass unterschiedliche Laserdiodentypen realisiert werden können. Dabei bleiben grundsätzlich die Vorteile der integrierten Monitordiode bezüglich zuverlässiger Signalerzeugung und geringer Herstellungskosten erhalten. Zunächst kann beim Laserdiodentyp zwischen einer horizontalen und einer vertikalen Lichtauskopplung unterschieden werden. Eine horizontale Lichtauskopplung wird erreicht, wenn die Frontfacette senkrecht zum Resonator angeordnet ist. Weist hingegen die Frontfacette einen Neigungswinkel β größer 0° und kleiner 90° bezogen auf die aktive Laserschicht im Winkel β gleich 0° auf, so wird eine vertikale Lichtauskopplung nach oben aus der Laserdiode heraus erreicht. Im Falle der geneigten Frontfacette sind bei der Laserdiode nach der Erfindung somit beide Facetten geneigt und arbeiten als zwei in umgekehrter Richtung wirkende Ablenkspiegel. Bevorzugt liegt dabei der Neigungswinkel von Rückfacette und/oder Frontfacette zwischen 90° und 60°. Ist auf der Oberseite der Laserdiode eine lichtundurchlässige Kontaktschicht (Laserkontakt) aufgebracht, so weist diese zum Lichtdurchtritt oberhalb der Frontfacette ein entsprechendes Fenster auf. Weiterhin kann vorteilhaft auf der Oberseite der Laserdiode eine Antireflexbeschichtung aufgebracht sein, durch die zusätzlich störende Reflexionen in die aktive Laserschicht vermieden werden.

Weiterhin kann eine Laserdiode nach der Erfindung mit vergrabener Heterostruktur (Buried Heterostructure, BH-Laserstruktur) oder mit einer Rippenwellenleiterstruktur (Ridge Waveguide, RW-Laserstruktur) konzipiert werden. Schließlich ist in die aktive Laserschicht ein DFB- oder DBR-Gitter (DFB Distributed Feed Back, DBR Distributed Bragg Reflector) integriert sein, sodass sich eine DFB- oder DBR-Laserstruktur ergibt. Diese Strukturen zeigen als Weiterentwicklung der Fabry-Perot-Laserstruktur den Vorteil, dass monomodiges Licht mit einer konstanten Wellenlänge in Abhängigkeit von den gewählten Gitterparametern erzeugt wird.

Weitere Ausführungsformen der Laserdiode nach der Erfindung sehen vor, dass die aktive Laserschicht und die aktive Diodenschicht jeweils ein Schichtenpaket umfassen. Hierbei kann es sich beispielsweise um eine MQW-Struktur (MQW Multi Quantum Well) handeln, die in einen optischen Wellenleiter eingebettet ist. Schließlich kann der Schichtenaufbau zur Erzeugung unterschiedlicher Emissionswellenlängen auf einem InP-, GaAs-, GaSb- oder GaN-Materialsystem basieren. Je nach Materialsystem ergeben sich entsprechende p-n-p- oder n-p-n-Schichtenfolgen. Insbesondere das InP-Materialsystem findet große Anwendung bei Laserdioden.

Die bei der optischen Signalübertragung bislang eingesetzten DFB-Laser sind in der Herstellung immer noch sehr kostenintensiv. So werden nach der Prozessierung eines Wafers mit DFB-Lasern zunächst Laserbarren gespalten. Um eine Einmodigkeit der Laserdioden zu erreichen, muss mindestens eine Facette der DFB-Laser entspiegelt werden. Hierfür muss jeder einzelne Laserbarren mit entsprechenden Werkzeugen angefasst und in geeignete Barrenhalter zum Einbau in eine Entspiegelungsanlage eingesetzt werden. Nach der Entspiegelung werden die Laserbarren dann wieder aus dem Barrenhalter herausgenommen. Barrenweise wird dann jeder einzelne Laser charakterisiert und anhand der Messergebnisse die Selektion vorgenommen. Anschließend werden die Laserbarren in Einzel-Laserchips gebrochen und die ungeeigneten Laserdioden aussortiert. Alle beschriebenen Barren-Prozesse sind jedoch sehr Zeit- und Personal-intensiv und damit teuer.

Bei der sich mit der Laserdiode nach der Erfindung mit integrierter Monitordiode ergebenden neuen DFB-Laserdiode mit Vertikalauskopplung des Laserlichtes kann das oben beschriebene Barren-Handling vollständig vermieden werden: Die Entspiegelung der Laserfacette erfolgt noch auf dem Wafer und auch die vollständige Charakterisierung und Selektion können mit Hilfe eines automatischen Waferprobers erfolgen. Die Herstellungskosten der vorgeschlagenen DFB-Laserdiode mit vertikaler Lichtauskopplung sind daher deutlich niedriger als bei Standard-DFB-Lasern. Die "on-wafer"-Testbarkeit, die bislang als wesentlicher Vorteil von VCSEL-Strukturen gilt, ist damit gleichermaßen auch auf "in-plane" Laserstrukturen übertragbar. Im Vergleich zu VCSELn sind aber bei der Laserdiode nach der Erfindung die optischen Ausgangsleistungen ungleich höher und Probleme hinsichtlich spatialer Multimodigkeit bestehen ebenfalls nicht.

In der Literatur sind bisher eine Vielzahl unterschiedlicher DFB-Laser mit Vertikaläuskopplung vorgestellt worden. In den meisten Fällen handelt es sich jedoch um DFB-Laserstrukturen, bei denen mit Hilfe eines DFB-Gitters zweiter Ordnung eine Auskopplung in vertikaler Richtung erreicht wird. Alternativ wurden auch Strukturen mit vertikal auskoppelnden DBR-Gittern vorgestellt. Die vertikale Auskopplung des Laserlichtes mittels eines integrierten 45°-Spiegels wurde ebenfalls schon vor vielen Jahren vorgeschlagen und ist beispielsweise aus der **Veröffentlichung** von K. Iga et. al., "Surface emitting semiconductor lasers" (IEEE Journ. of Quantum electron., vol. 24, 1988, pp1845-1855) bekannt. Eine derartige vertikale Lichtauskopplung über eine von der aktiven Laserschicht weg geneigten Frontfacette in der Kombination mit einer parallel geneigten Rückfacette als Ablenkspiegel, einer zusätzlich integrierten Monitordiode und einer on-Wafer-Entspiegelung der Frontfacette, wie sie eine Ausführungsform der Laserdiode nach der Erfindung umfasst, ist aus dieser Veröffentlichung jedoch nicht bekannt. Somit ergeben sich bei der Laserdiode nach der Erfindung vorteilhaft gegenüber bekannten Laserstrukturen eine erhebliche Vereinfachung der Herstellung, eine Charakterisierung und Selektion im Vergleich zu konventionellen Lasern durch on-Wafer-Technologie, indem Entspiegelung, Charakterisierung und Selektion auf dem Wafer vorgenommen werden können; eine Integration einer Monitordiode ohne nennenswerten technologischen Zusatzaufwand und daher Kostenreduktion, eine im Vergleich zu konventionellen Laserdioden mit vertikaler Kavität erheblich größere Ausgangsleistung und ein Monomode-Verhalten auch bei hohen Leistungen. Die vertikale monolithische Integration ist darüber hinaus Platz sparend, sowohl hinsichtlich der pro Laser-Monitordiode-Bauelement beanspruchten Waferfläche als auch hinsichtlich des Platzbedarfs in Modulen, bei denen Kompaktheit und so genanntes "foot-print" immer wichtiger werden.

### Ausführungsbeispiele

Einige Ausbildungsformen der Laserdiode mit integrierter Monitordiode nach der Erfindung werden nachfolgend zum weiteren Verständnis der Erfindung anhand der schematischen Figuren näher erläutert. Dabei zeigt:
- **Figur 1**: einen Längsschnitt durch eine DFB-Laserdiode mit vertikaler Lichtauskopplung,
- **Figur 2**: einen Querschnitt durch eine Laserdiode mit BH-DFB-Laserstruktur,
- **Figur 3**: Charakterisierungsdiagramme einer Laserdiode mit BH-DFB-Laserstruktur und vertikaler Lichtauskopplung,
- **Figur 4**: einen Längsschnitt durch eine DFB-Laserdiode mit vertikaler Lichtauskopplung mit zusätzlicher metallischer Verspiegelung und
- **Figur 5**: einen Längsschnitt durch eine DFB-Laserdiode mit vertikaler Lichtauskopplung mit einem zusätzlichen vertikalen Spiegel.

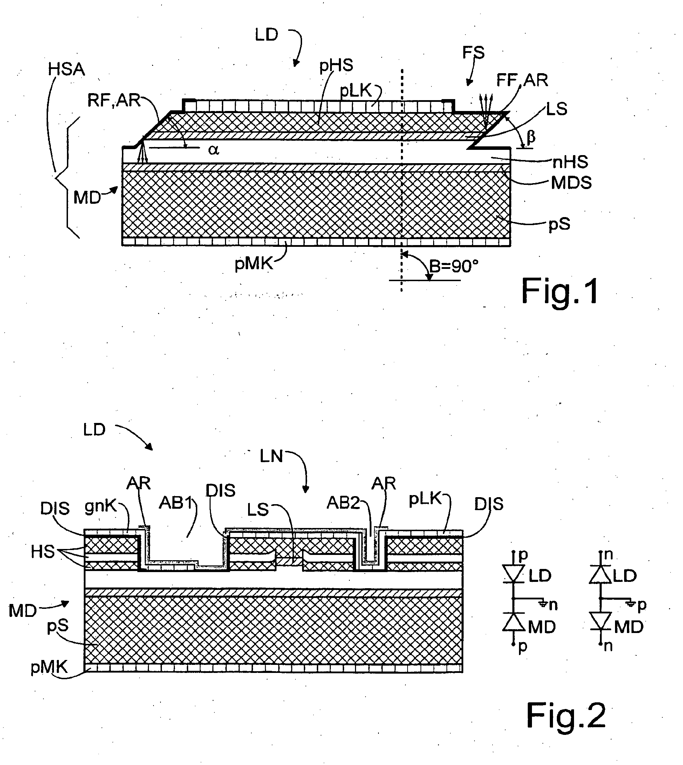

Die **Figur 1** zeigt eine Laserdiode **LD** mit einem monolithisch integrierten Halbleiterschichtaufbau **HSA**, der aus einer ersten p-leitenden Halbleiterschicht, im gewählten Ausführungsbeispiel handelt es sich dabei um eine p-leitende Substratschicht **pS**, einer n-leitenden Halbleiterschicht **nHS**, einer weiteren p-leitenden Halbleiterschicht **pHS** und einer zwischen den oberen beiden Halbleiterschichten **nHS**, **pHS** angeordneten aktiven Laserschicht **LS** besteht. In dieser Ausführungsform enthält die aktive Laserschicht **LS** ein zusätzlich integriertes DFB-Gitter.

Es ergibt sich somit ein p-n-p-Halbleiterschichtaufbau **HSA**, der im gewählten Ausführungsbeispiel auf dem InP-Materialsystem beruht. Auf der einen Seite wird der Halbleiterschichtaufbau **HSA** von einer Licht auskoppelnden Frontfacette **FF**, auf der anderen Seite von einer Licht rückkoppelnden Rückfacette **RF** begrenzt.

Die Rückfacette **RF** weist einen Neigungswinkel α bezogen auf die aktive Laserschicht **LS** im Winkel α = 0° auf. Dieser Neigungswinkel α liegt zwischen 90° (Grenzfall vertikale Rückfacette **RF**: kein Licht auf eine Monitordiodenschicht **MDS**; maximale Reflexion für die Laserdiode **LD**, die Monitordiode **MD** detektiert nur Streulicht entlang der Laserkavität) und 0° (Grenzfall horizontale Rückfacette **RF**). Im gewählten Ausführungsbeispiel ist ein Neigungswinkel α von 45° dargestellt. Die Wahl des Neigungswinkels α ermöglicht eine Einstellung der die Monitordiodenschicht **MDS** treffenden Laserlicht-Intensität und gleichzeitig eine Einstellung der für-die Laserdiode **LD** wirksamen Reflexion an der Rückfacette **RF**.

Unterhalb der aktiven Laserschicht **LS** ist zwischen den unteren beiden n-p-Halbleiterschichten, das heißt zwischen der n-leitenden Schicht **nHS** und der p-leitenden Substratschicht **pS**, die aktive Monitordiodenschicht **MDS** angeordnet. Die Monitordiode **MD** ist somit optisch parallel zur Laserdiode **LD** geschaltet, wohingegen die elektrische Schaltung zwischen beiden Dioden **LD**, **MD** elektrisch seriell erfolgt. Im gezeigten Ausführungsbeispiel erstreckt sich die Monitordiode **MD** nicht nur im Bereich der Rückfacette **RF,** sondern flächig unter der gesamten aktiven Laserschicht **LS**, sodass sie einfach bei der Herstellung abgeschieden werden kann. Das im p-n-p-Halbleiterschichtaufbau **HSA** erzeugte Laserlicht gelangt auch zu der geneigten Rückfacette **RF** und wird dort anteilig in Abhängigkeit vom gewählten Neigungswinkel α nach unten zur aktiven Monitordiodenschicht **MDS** reflektiert (in der **Figur 1** durch Pfeile angedeutet). Durch eine entsprechende Kontaktierung der Monitordiodenschicht **MDS** wird diese zu einer Monitordiode **MD** ausgebildet, mit deren Hilfe die erzeugte Laserlichtleistung beobachtet und geregelt werden kann. Im gewählten Ausführungsbeispiel ist die Monitordiode **MD** zwischen einem p-leitenden Monitorkontakt **pMK**, der großflächig auf der Unterseite der p-leitenden Substratschicht **pS** angeordnet ist und somit ebenfalls einfach herstellbar ist, und einem mit der Laserdiode **LD** gemeinsamen n-leitenden Kontakt **gnK** (siehe **Figur 2**) auf der Oberseite der Laserdiode **LD** kontaktiert. Die Laserdiode **LD** wird zwischen dem gemeinsamen n-leitenden Kontakt **gnK** und einem ebenfalls auf der Oberseite angeordneten p-leitenden Laserkontakt **pLK** kontaktiert. Somit wird die Laserdiode **LD** in Durchflussrichtung und die Monitordiode **MD** in Sperrrichtung betrieben, sodass sich beide Dioden **LD**, **MD** nicht gegenseitig stören (vergleiche **Figur 2**). Wird eine n-leitende Substratschicht eingesetzt (n-p-n-Halbleiterschichtaufbau **HSA**), so wird entsprechend ein gemeinsamer p-leitender Kontakt verwendet (in der **Figur 1** nicht dargestellt).

In der **Figur 1** ist eine Laserdiode **LD** mit einer vertikalen Lichtauskopplung nach oben dargestellt. Dazu weist auch die Frontfacette **FF** einen Neigungswinkel β größer 0° und kleiner 90° bezogen auf die aktive Laserschicht **LS** im Winkel β gleich 0° auf, sodass die Frontfacette **FF** in dieselbe Richtung geneigt ist wie die Rückfacette **RF**. Der Neigungswinkel β liegt ebenfalls zwischen 90° (Grenzfall vertikale Frontfacette **FF**) und 0° (Grenzfall horizontale Frontfacette **FF**). Im ausgeführten Beispiel beträgt auch der Neigungswinkel β 45°, sodass beide Facetten **FF**, **RF** parallel verlaufen. Da aber die Rückfacette **RF** zur Laserschicht **LS** geneigt ist und die Frontfacette **FF** von dieser weg, reflektieren sie das Laserlicht in gewünschter Weise einmal nach unten und einmal nach oben (in der **Figur 1** durch Pfeile angedeutet). Auf der Oberseite der Laserdiode **LD** ist eine Kontaktmetallisierung in Form eines p-leitenden Laserkontaktes **pLK** aufgebracht, die oberhalb der geneigten Frontfacette **FF** ein Fenster **FS** aufweist.

Der Grenzfall β = 90° für die Frontfacette **FF** ist in der **Figur 1** durch eine vertikale gestrichelte Linie angedeutet. In diesem Fall wird eine horizontale Lichtauskopplung erreicht (in der **Figur 1** nicht dargestellt).

Im gezeigten Ausführungsbeispiel in **Figur 1** ist die Frontfacette **FF** mit einer Antireflexbeschichtung **AR** zur Vermeidung von störenden Rückreflexionen beschichtet. Zusätzlich kann auch die Rückfacette **RF** eine Antireflexbeschichtung **AR** aufweisen. Zur Ausbildung einer DFB- oder DBR-Laserdiode weist die aktive Laserschicht **LS** ein integriertes DFB- oder DBR-Gitter auf.

In der **Figur 2** (hier nicht erwähnte Bezugszeichen sind der bzw. den vorhergehenden Figuren zu entnehmen) ist ein Querschnitt durch die Laserdiode **LD** gemäß **Figur 1** mittig zwischen den Facetten **RF, FF** dargestellt. Zu erkennen ist, dass die Laserdiode **LD** mit BH-Struktur mit der vergrabenen aktiven Laserschicht **LS** in einem durch zwei Ätzgruben **AB1**, **AB2** lateral begrenzten Laserstreifen **LN** ausgebildet ist. Auf dem Laserstreifen **LN** und der Laserdiode rechts von der rechten Ätzgrube **AB2** ist der p-leitende Laserkontakt **pLK** der Laserdiode **LD** zu erkennen. In der linken Ätzgruben **AB1** und auf der Laserdiode **LD** links von der linken Ätzgrube **AB1** ist der gemeinsame n-leitende Kontakt **gnK** von Laserdiode **LD** und Monitordiode **MD** angeordnet. Dabei sind der p-leitende Laserkontakt **pLK** und der gemeinsame n-leitende Kontakt **gnK** jeweils durch eine dielektrische Isolationsschicht **DIS** von den nicht zu kontaktierenden Halbleiterschichten **HS** elektrisch isoliert. Auf der Rückseite des p-leitenden Substrats **pS** ist der p-leitende Monitorkontakt **pMK** flächig angeordnet. Auf dem Laserstreifen **LN** und über die beiden Ätzgruben **AB1**, **AB2** hinweg ist die Antireflexbeschichtung **AR** dargestellt.

Rechts neben dem Querschnitt ist in der **Figur 2** das Ersatzschaltbild für die Schaltung von Laser- und Monitordiode **LD**, **MD** sowohl für einen p-n-p-Halbleiterschichtaufbau **HSA** als auch für einen n-p-n-Halbleiterschichtaufbau **HSA** dargestellt. Zu erkennen ist, dass die Laserdiode **LD** immer in Durchflussrichtung und die Monitordiode **MD** immer in Sperrrichtung für den Strom betrieben wird und die beiden Dioden **LD**, **MD** sich nicht gegenseitig stören. Weiterhin ist zu erkennen, dass sich einmal eine n-p- und einmal eine p-n-Monitordiode **MD** ergibt.

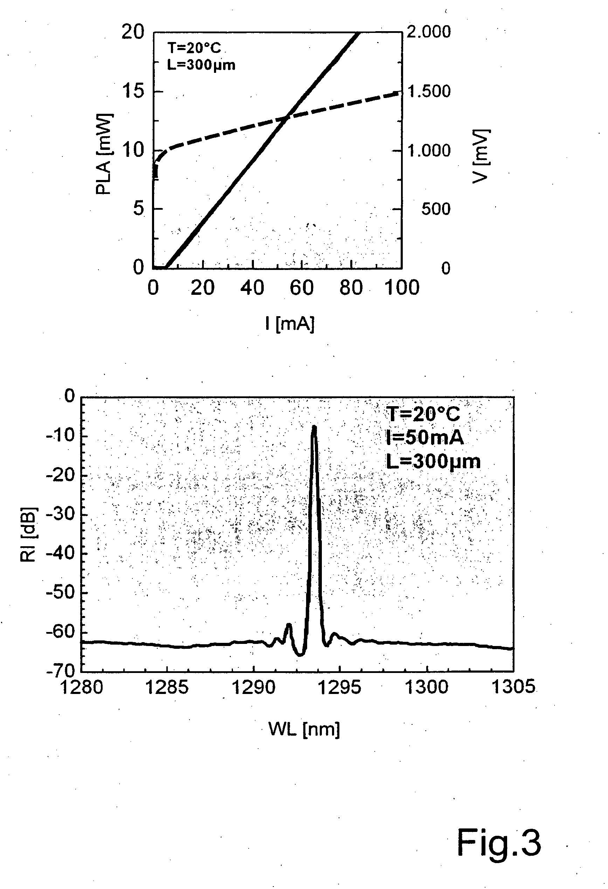

In der **Figur 3** ist die Charakterisierung einer hergestellten Laserdiode **LD** mit DFB-Gitter nach der Erfindung mit BH-Struktur und vertikaler Lichtausköpplung gemäß **Figuren 1 und 2** aufgezeigt. Im oberen Diagramm wird die optische Ausgangsleistung eines **L** = 300 µm langen Laserdiode **LD** (Pulsausgangsleistung **PAL** in mW) über dem Strom (Strom **I** in mA) bei einer Betriebstemperatur **T** von 20°C aufgezeigt (durchgezogene Kurve). Gleichzeitig wird der Verlauf der Spannung **V** in mV über dem Strom aufgezeigt (gestrichelte Kurve). Das zugehörige optische Spektrum (Wellenlänge **WL** in nm über relativer Intensität **RI** in dB) bei einem Strom **I** = 50 mA ist im unteren Diagramm dargestellt. Die Seitenmodenunterdrückung der Laserdiode **LD** beträgt mehr als 45 dB.

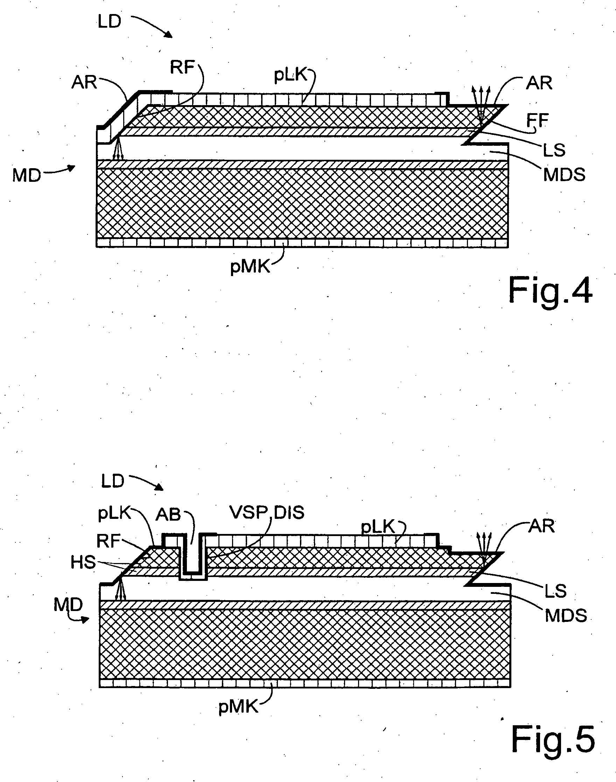

In der **Figur 4** (hier nicht erwähnte Bezugszeichen sind der bzw. den vorhergehenden Figuren zu entnehmen) ist eine Laserdiode **LD** dargestellt, bei der die Metallisierung des p-leitenden Laserkontakts **pLK** über die Rückfacette **RF** hinausreicht. Diese zusätzliche Metallisierung führt zu einer Erhöhung der Reflektivität der Rückfacette **RF** im Sinne einer Verspiegelung. Auf der Frontfacette **FF** ist wiederum eine Antireflexbeschichtung **AR** vorgesehen.

Die **Figur 5** (hier nicht erwähnte Bezugszeichen sind der bzw. den vorhergehenden Figuren zu entnehmen) zeigt für eine Laserdiode **LD** die Integration eines zusätzlichen vertikalen Spiegels **VSP** vor der Rückfacette **RF** zur Erzielung steuerbarer Reflexion. Ein Teil des Laserlichts erreicht immer noch die Rückfacette **RF** und wird nach unten auf die Monitordiode **MD** abgelenkt. Im gezeigten Ausführungsbeispiel ist der zusätzliche vertikale Spiegel **VSP** als metallisierte Ätzgrube ausgebildet, die mit einer dielektrischen Isolationsschicht **DIS** gegenüber der beiden oberen p-n- bzw. n-p-Halbleiterschichten **HS** elektrisch isoliert ist. Auf beiden Facetten **RF**, **FF** ist wiederum eine Antireflexbeschichtung **AR** vorgesehen.

### Bezugszeichenliste

- **AB**: Ätzgrube
- **AR**: Antireflexbeschichtung
- **DIS**: dielektrische Isolationsschicht
- **FF**: Frontfacette
- **FS**: Fenster
- **gnK**: gemeinsamer n-leitender Kontakt
- **LD**: Laserdiode
- **HSA**: Halbleiterschichtaufbau
- **I**: Strom
- **LN**: Laserstreifen
- **LS**: aktive Laserschicht
- **MD**: Monitordiode
- **MDS**: Monitordiodenschicht
- **nHS**: n-leitende Halbleiterschicht
- **PAL**: Pulsausgangsleistung
- **pHS**: p-leitende Halbleiterschicht
- **pLK**: p-leitender Laserkontakt
- **pMK**: p-leitender Monitorkontakt
- **pS**: p-leitende Substratschicht
- **RI**: relative Intensität
- **RF**: Rückfacette
- **T**: Betriebstemperatur
- **VSP**: zusätzlicher vertikaler Spiegel
- **WL**: Wellenlänge
- **α**: Neigungswinkel RF
- **β**: Neigungswinkel FF

## Patentansprüche

1. Laserdiode mit monolithisch-integriertem p-n-p- oder n-p-n-Halbleiter-schichtaufbau mit einer aktiven Laserschicht (LS) zwischen den oberen beiden p-n- oder n-p-Halbleiterschichten auf einer Substratschicht,
einer Licht auskoppelnden Frontfacette (FF),
einer Licht rückkoppelnden, unter einem Neigungswinkel α zur aktiven Laserschicht geneigten Rückfacette (RF),
wobei der Neigungswinkel α größer 0° und kleiner 90° bezogen auf die aktive Laserschicht (LS) im Winkel α gleich 0° aufweist,
und mit einer integrierten n-p- oder p-n-Monitordiode mit einer flächigen aktiven Monitordiodenschicht,
wobei die Laserdiode (LD) in Durchlassrichtung und die Monitordiode (MD) in Sperrrichtung für den Strom geschaltet ist.
wobei
in die aktive Laserschicht (LS) ein DFB- oder DBR-Gitter integrierte ist,
und dass die aktive Monitordiodenschicht (MDS) zumindest im Bereich der Rückfacette (RF) unterhalb der aktiven Laserschicht (LS) zwischen den unteren beiden n-p- oder p-n-Halbleiterschichten (HS) angeordnet ist.

2. Laserdiode nach Anspruch 1,
wobei
die unterste p- oder n-Halbleiterschicht (HS) als p- oder n-leitende Substratschicht (pS) ausgebildet und der n- oder p-leitende Kontakt (gnK) der Monitordiode (MD) auf der Oberseite der Laserdiode (LD) gleichzeitig als n-oder p-leitender Kontakt (gnK) der Laserdiode (LD) ausgebildet ist.

3. Laserdiode nach Anspruch 1 oder 2,
wobei
der n-leitende Kontakt (gnK) und der p-leitende Kontakt (pLK) der Laserdiode (LD) elektrisch voneinander isoliert auf der Oberseite der Laserdiode (LD) angeordnet sind.

4. Laserdiode nach einem der Ansprüche 1 bis 3,
wobei
vor der Rückfacette (RF) ein zusätzlicher vertikaler Spiegel (VSP) mit einer Tiefe bis einschließlich zur aktiven Laserschicht (LS) angeordnet ist.

5. Laserdiode nach einem der Ansprüche 1 bis 4,
wobei
die Rückfacette (RF) und/oder der zusätzliche vertikale Spiegel (VSP) zusätzlich mit einer metallischen oder dielektrischen Verspiegelung belegt sind.

6. Laserdiode nach einem der Ansprüche 1 bis 5,
wobei
die Frontfacette (FF) senkrecht zur aktiven Laserschicht (LS) angeordnet ist.

7. Laserdiode nach Anspruch 6,
wobei
die Frontfacette (FF) zusätzlich noch mit einer entspiegelnden Antireflexschicht (AR) oder einer dielektrischen Verspiegelungsschicht belegt ist:

8. Laserdiode nach einem der Ansprüche 1 bis 5,
wobei
die Frontfacette (FF) einen Neigungswinkel β größer 0° und kleiner 90° bezogen auf die aktive Laserschicht (LS) im Winkel β gleich 0° aufweist.

9. Laserdiode nach Anspruch 8,
wobei
die Frontfacette (FF) zusätzlich noch mit einer metallischen oder dielektrischen Verspiegelungsschicht belegt ist.

10. Laserdiode nach einem der Ansprüche 1 bis 5 oder 8 oder 9,
wobei
die Rückfacette (RF) und/oder die Frontfacette (FF) einen Neigungswinkel α, β größer oder gleich 60° und kleiner 90° aufweist.

11. Laserdiode nach einem der Ansprüche 8 bis 10,
wobei
auf der Oberseite der Laserdiode (LD) ein lichtundurchlässiger p- oder n-leitender Laserkontakt (pLK) aufgebracht ist, der oberhalb der geneigten Frontfacette (FF) ein Fenster (FS) aufweist.

12. Laserdiode nach einem der Ansprüche 1 bis 11,
wobei
auf der Oberseite der Laserdiode (LD) eine Antireflexbeschichtung (AR) oder eine dielektrische Verspiegelungsschicht aufgebracht ist.

13. Laserdiode nach einem der Ansprüche 1 bis 12,
wobei
die aktive Laserschicht (LS) in einem durch zwei Ätzgruben (AB1, AB2) lateral begrenzten Laserstreifen (LN) vergraben ist.

14. Laserdiode nach einem der Ansprüche 1 bis 13,
wobei
die aktive Laserschicht (LS) in einem Rippenwellenleiter angeordnet ist.

15. Laserdiode nach einem der Ansprüche 1 bis 14,
wobei
die aktive Laserschicht (LS) und die aktive Monitordiodenschicht (MDS) jeweils ein Schichtenpaket umfassen.

16. Laserdiode nach einem der Ansprüche 1 bis 15
wobei
der Halbleiterschichtaufbau (HSA) auf einem InP-, GaAs-, GaSb- oder GaN-Materialsystem- basiert.

## Claims

1. Laser diode having a monolithically integrated p-n-p or n-p-n semiconductor layer structure with an active laser layer (LS) between the two upper p-n or n-p semiconductor layers on a substrate layer,
a light decoupling front facet (FF),
a light feeding-back rear facet (RF) inclined at an angle of inclination α relative to the active laser layer,
wherein the angle of inclination α is greater than 0° and less than 90°, based on the active laser layer (LS) at an angle α of equal to 0°,
and with an integrated n-p or p-n monitor diode having a flat active monitor diode layer,
wherein the laser diode (LD) is switched in the forward direction and the monitor diode (MD) in the reverse direction for the current,
wherein
a DFB or DBR grating is integrated into the active laser layer (LS)
and wherein the active monitor diode layer (MDS) is arranged, at least in the region of the rear facet (RF), below the active laser layer (LS) between the two lower n-p or p-n semiconductor layers (HS).

2. Laser diode according to claim 1,
wherein
the lowermost p- or n-semiconductor layer (HS) is formed as a p- or n-type substrate layer (pS) and the n- or p-type contact (gnK) of the monitor diode (MD) on the top side of the laser diode (LD) is simultaneously formed as n- or p-type contact (gnK) of the laser diode (LD).

3. Laser diode according to claim 1 or 2,
wherein
the n-type contact (gnK) and the p-type contact (pLK) of the laser diode (LD) are arranged on the top side of the laser diode (LD) so as to be electrically insulated from one another.

4. Laser diode according to any of claims 1 to 3,
wherein
an additional vertical mirror (VSP) with a depth of up to, and including, the active laser layer (LS) is arranged in front of the rear facet (RF).

5. Laser diode according to any of claims 1 to 4,
wherein
the rear facet (RF) and/or the additional vertical mirror (VSP) are additionally covered with a metallic or dielectric mirror coating.

6. Laser diode according to any of claims 1 to 5,
wherein
the front facet (FF) is arranged perpendicularly to the active laser layer (LS).

7. Laser diode according to claim 6,
wherein
the front facet (FF) is additionally covered with a reflection-reducing antireflex layer (AR) or a dielectric mirror-coating layer.

8. Laser diode according to any of claims 1 to 5,
wherein
the front facet (FF) has an angle of inclination ß of greater than 0° and less than 90°, based on the active laser layer (LS), at an angle ß of equal to 0°.

9. Laser diode according to claim 8,
wherein
the front facet (FF) is additionally coated with a metallic or dielectric mirror coating layer.

10. Laser diode according to any of claims 1 to 5 or 8 or 9,
wherein
the rear facet (RF) and/or the front facet (FF) has an angle of inclination α, ß of greater than or equal to 60° and less than 90°.

11. Laser diode according to any of claims 8 to 10,
wherein
on the top side of the laser diode (LD) a lightproof p- or n-type laser contact (pLK) is applied which has a window (FS) above the inclined front facet (FF).

12. Laser diode according to any of claims 1 to 11,
wherein
on the top side of the laser diode (LD) an antireflex coating (AR) or a dielectric mirror-coating layer is applied.

13. Laser diode according to any of claims 1 to 12,
wherein
the active laser layer (LS) is buried in a laser strip (LN) confined laterally by two etch pits (AB1, AB2).

14. Laser diode according to any of claims 1 to 13,
wherein
the active laser layer (LS) is arranged in a ridge waveguide.

15. Laser diode according to any of claims 1 to 14,
wherein
the active laser layer (LS) and the active monitor diode layer (MDS) each comprise a layer package.

16. Laser diode according to any of claims 1 to 15,
wherein
the semiconductor layer structure (HSA) is based on an InP, GaAs, GaSb or GaN material system.

## Revendications

1. Diode laser comportant une structure de couches semi-conductrices p-n-p ou n-p-n intégrée de manière monolithique comportant une couche laser active (LS) entre les deux couches semi-conductrices p-n ou n-p supérieures sur une couche de substrat,
une facette avant de couplage en sortie de lumière (FF),
une facette arrière (RF) de rétro-couplage de lumière sous un angle d'inclinaison α appropriée pour la couche laser active,
dans lequel l'angle d'inclinaison α présente une valeur supérieure à 0° et inférieure à 90° par rapport à la couche laser active (LS) à un angle α égal à 0°,
et comportant une diode de contrôle n-p ou p-n intégrée ayant une couche de diode de contrôle active plane,
dans lequel la diode laser (LD) est commutée en sens passant et la diode de contrôle (MD) est commutée en sens non passant pour le courant,
dans lequel un réseau DFB ou DBR est intégré à la couche laser active (LS), et la couche de diode de contrôle active (MDS) est disposée au moins dans la région de la facette arrière (RF) en dessous de la couche laser active (LS) entre les deux couches semi-conductrices n-p ou p-n (HS) inférieures.

2. Diode laser selon la revendication 1,
dans laquelle la couche semi-conductrice p ou n (HS) la plus basse est réalisée sous la forme d'une couche de substrat (pS) à conduction p ou n et le contact à conduction n ou p (gnK) de la diode de contrôle (MD) sur la face supérieure de la diode laser (LD) est réalisé en même temps que le contact à conduction n ou p (gnK) que la diode laser (LD).

3. Diode laser selon la revendication 1 ou 2,
dans laquelle le contact à conduction n (gnK) et le contact à conduction p (pLK) de la diode laser (LD) sont disposés de manière électriquement isolée l'un de l'autre sur la face supérieure de la diode laser (LD).

4. Diode laser selon l'une quelconque des revendications 1 à 3
dans laquelle un miroir vertical supplémentaire (VSP) ayant une profondeur s'étendant jusqu'à la couche laser active (LS) incluse est disposé en amont de la facette arrière (RF).

5. Diode laser selon l'une quelconque des revendications 1 à 4,
dans laquelle la facette arrière (RF) et/ou le miroir vertical supplémentaire (VSP) sont en outre revêtus d'une couche réfléchissante métallique ou diélectrique.

6. Diode laser selon l'une quelconque des revendications 1 à 5,
dans laquelle la facette avant (FF) est disposée perpendiculairement à la couche laser active (LS).

7. Diode laser selon la revendication 6,
dans laquelle la facette avant (FF) est en outre également revêtue d'une couche antiréfléchissante à traitement antireflet (AR) ou d'une couche réfléchissante diélectrique.

8. Diode laser selon l'une quelconque des revendications 1 à 5,
dans laquelle la facette avant (FF) présente un angle d'inclinaison β supérieur à 0° et inférieur à 90° par rapport à la couche laser active (LS) à un angle β égal à 0°.

9. Diode laser selon la revendication 8,
dans laquelle la facette avant (FF) est en outre également revêtue d'une couche réfléchissante métallique ou diélectrique.

10. Diode laser selon l'une quelconque des revendications 1 à 5 ou 8 ou 9,
dans laquelle la facette arrière (RF) et/ou la facette avant (FF) présente un angle d'inclinaison α, β supérieur ou égal à 60° et inférieur à 90°.

11. Diode laser selon l'une quelconque des revendications 8 à 10,
dans laquelle un contact laser à conduction p ou n (pLK), qui présente au-dessus de la facette avant appropriée (FF) une fenêtre (FS), est déposé sur la face supérieure de la diode laser (LD).

12. Diode laser selon l'une quelconque des revendications 1 à 11,
dans laquelle une couche antiréfléchissante (AR) ou une couche réfléchissante diélectrique est déposée sur la face supérieure de la diode laser (LD).

13. Diode laser selon l'une quelconque des revendications 1 à 12,
dans laquelle la couche laser active (LS) est enterrée dans une bande laser (LN) délimitée latéralement par deux tranchées gravées (AB1, AB2).

14. Diode laser selon l'une quelconque des revendications 1 à 13,
dans laquelle la couche laser active (LS) est disposée dans un guide d'ondes nervuré.

15. Diode laser selon l'une quelconque des revendications 1 à 14,
dans laquelle la couche laser active (LS) et la couche de diode de contrôle active (MDS) comprennent respectivement un paquet de couches.

16. Diode laser selon l'une quelconque des revendications 1 à 15,
dans laquelle la structure de couches semi-conductrices (HSA) est à base d'un système de matériau d'InP, de GaAs, de GaSb ou de GaN.
